# EUROPÄISCHE PATENTSCHRIFT

(11) **EP 3 111 516 B1**
(45) Veröffentlichungstag und Bekanntmachung des Hinweises auf die Patenterteilung: **08.05.2019**
(21) Anmeldenummer: 15706034.4
(22) Anmeldetag: 24.02.2015
(51) Int. Cl.: H01R 9/26, H02J 1/06, H05K 7/02

(54) **ANORDNUNG ZUR STROMVERTEILUNG IN EINEM NIEDERSPANNUNGSSYSTEM**
ASSEMBLY FOR DISTRIBUTING CURRENT IN A LOW-VOLTAGE SYSTEM
DISPOSITIF DE DISTRIBUTION DE COURANT DANS UN SYSTÈME BASSE TENSION

(30) Priorität: 24.02.2014 DE 202014100829 U
(43) Veröffentlichungstag der Anmeldung: 04.01.2017
(73) Patentinhaber: Weidmüller Interface GmbH & Co. KG, 32758 Detmold (DE)
(72) Erfinder: BÖCKER, Marc, 32839 Steinheim (DE); GERKENS, Michael, 33617 Bielefeld (DE); HÄHNEL, Andreas, 32609 Hüllhorst-Schnathorst (DE); LANGE, Stephan, 32657 Lemgo (DE); SCHÜRMANN, Klaus, 32791 Lage (DE); TEMPEL, Ralph, 32760 Detmold (DE)
(74) Vertreter: Kleine, Hubertus
(86) Internationale Anmeldenummer: PCT/EP2015/053854
(87) Internationale Veröffentlichungsnummer: WO 2015/124800

(56) Entgegenhaltungen:
- US-A- 3 054 024
- US-A- 4 680 674

## Beschreibung

Die Erfindung betrifft eine Anordnung zur Stromverteilung in einem Niederspannungssystem, wobei die Anordnung mehrere scheibenförmige, aneinanderreihbare und auf eine Tragschiene aufsetzbare, insbesondere aufrastbare Module umfasst. Mindestens eines der Module ist ein Einspeisemodul, mindestens eines ein Sicherungsmodul und mindestens eines ein Verteilermodul.

Anlagen zur industriellen Automatisierung und/oder zur Gebäudeautomatisierung bzw. zur Überwachung technischer Prozesse umfassen häufig Komponenten, die mit Gleichstrom im Niederspannungsbereich, häufig im Bereich von 24 Volt, versorgt werden. Solche Komponenten sind beispielsweise Ein-/Ausgabeeinheiten von industriellen Steuerungssystemen und/oder Sensoren und Messwertaufnehmer zur Auswertung von Sensorsignalen.

Da in größeren Systemen eine Mehr- oder Vielzahl solcher mit Gleichstrom im Niederspannungsbereich zu versorgenden Komponenten vorhanden sein kann, ist eine gemeinsam von mehreren Komponenten genutzte Stromversorgungseinheit sinnvoll. Entsprechend muss der von der Stromversorgungseinheit bereitgestellte Gleichstrom an die Komponenten verteilt werden, wobei eine Absicherung einzelner Komponenten oder eine gemeinsame Absicherung einer (Unter-) Gruppe dieser Komponenten gewünscht ist.

Zu diesem Zweck sind Sicherungsmodule bekannt, die elektronische oder konventionelle elektromechanische oder Schmelzsicherungen aufweisen und die zwischen die Stromversorgungseinheit und eine oder mehrere der zur versorgenden Komponenten geschaltet werden können. Weiterhin sind Verteilerklemmen bekannt, die zur Verteilung verschiedener Potentiale (positives und negatives Ausgangspotential der Stromversorgungseinheit; abgesichertes Potential) verwendet werden können. Die Sicherungsmodule und die Verteilerklemmen sind dabei bevorzugt mit einer Aufnahmevorrichtung ausgestattet, mit der sie auf eine Tragschiene montiert werden können. Somit ist eine Montage innerhalb eines üblicherweise für die industrielle Automatisierung oder die Gebäudeautomation verwendeten Schaltkastens möglich. Nachteilig bei den beschriebenen Sicherungsmodulen und den Verteilerklemmen ist ein hoher Aufwand an Verdrahtung, durch die die einzelnen Module untereinander verbunden werden.

Ein modular aufgebautes System mit einer gemeinsam genutzten Stromversorgungseinheit ist aus der Druckschrift US 4,680,674 A bekannt. Die Schrift beschreibt ein modulares Computersystem, bei dem verschiedene Module unterschiedlicher Dicke, aber mit gleichem Umriss, hintereinander angeordnet werden können. Die Module selbst weisen Kontakte an ihren Seitenflächen, also an den gegeneinander liegenden Flächen, auf, die beim Aneinandereihen der Module unmittelbar miteinander kontaktieren, um unter anderem Versorgungsstrom weiterzuleiten. Die Druckschrift US 3,054,024 A betrifft ein modulares Radiosystem, bei dem in ähnlicher Weise Steckkontakte an aufeinander gesetzten Seitenflächen von Module vorgesehen sind, die beim Aneinanderreihen der Module unmittelbar miteinander kontaktieren

Derartige Systeme, bei dem eine Kontaktierung unmittelbar beim Aneinanderreihen vorgenommen wird, sind jedoch für die eingangs genannte Niederspannungs-Stromverteilung nicht geeignet, da eine wahlweise und damit flexible Kontaktierung verschiedener Module nicht erfolgen kann.

Es ist eine Aufgabe der vorliegenden Erfindung, eine Anordnung der eingangs genannten Art zur Stromverteilung in einem Niederspannungssystem zu schaffen, die mit geringem Verdrahtungsaufwand aufgebaut werden kann. Dabei soll die Stromverteilung flexibel sein und eine Versorgung möglichst vieler Komponenten in beliebiger Aufteilung auf unterschiedlich abgesicherte Gruppen erlauben.

Diese Aufgabe wird durch eine Anordnung mit den Merkmalen des unabhängigen Anspruchs gelöst. Vorteilhafte Ausgestaltungen und Weiterbildungen sind in den abhängigen Ansprüchen angegeben.

Eine erfindungsgemäße Anordnung der eingangs genannten Art zeichnet sich dadurch aus, dass das mindestens eine Einspeisemodul, das mindestens eine Sicherungsmodul und das mindestens eine Verteilermodul jeweils mindestens einen Anschluss für einen ersten Querverbinder für ein positives Potential und einen Anschluss für einen zweiten Querverbinder für ein negatives Potential aufweisen, wobei das Sicherungsmodul und das Verteilermodul darüber hinaus jeweils mindestens einen weiteren Anschluss für mindestens einen weiteren Querverbinder für ein durch das Sicherungsmodul abgesichertes Potential aufweisen, um mindestens eines der beiden über den ersten oder zweiten Querverbinder zugeführten Potentiale über den mindestens einen weiteren Querverbinder abgesichert weiterzuleiten, wobei die Anschlüsse für den jeweiligen Querverbinder an den Gehäusen der einzelnen Modulen so in einer Flucht liegen, dass sie durch einen durchgehenden, geraden Querverbinder miteinander verbunden werden können.

Bei der anmeldungsgemäßen Anordnung sind die zur Stromverteilung benötigten Funktionalitäten - Einspeisung, Absicherung, Verteilung - auf unterschiedliche Module aufgeteilt. Durch die Querverbinder für den eingespeisten Strom und den mindestens einen weiteren Querverbinder für den abgesicherten Strom können die Module jedoch beliebig untereinander kombiniert werden und es kann eine Stromverteilung ohne aufwendige Verdrahtung aufgebaut werden. Einem Einspeisemodul kann ein oder können mehrere Sicherungsmodule zugeordnet werden, an das oder die sich Verteilermodule anschließen. So können ausgehend von einem Einspeisemodul, das beispielsweise mit einer Stromversorgungseinheit verbunden ist, mehrere einzeln abgesicherte Untergruppen von stromverbrauchenden Komponenten versorgt werden. Dadurch, dass die Anschlüsse für den jeweiligen Querverbinder an den Gehäusen der einzelnen Module in einer Flucht liegen, können sie durch einen einfach ausgebildeten und somit leicht und flexibel ablängbaren Querverbinder miteinander verbunden werden.

Bei der anmeldungsgemäßen Anordnung sind bevorzugt die Querverbinder und ggf. auch der mindestens eine weitere Querverbinder mit einer vorgegebenen und für alle Querverbinder gleich hohen maximalen Strombelastbarkeit ausgebildet. Dieses gilt insbesondere auch für den Querverbinder, der das negative Potential der Stromversorgungseinheit verteilt. Auf diese Weise kann ausgehend von Einspeiseanschlüssen sämtlicher von einer Stromversorgungseinheit bereitgestellter Strom ohne eine zusätzliche Hilfsverdrahtung verteilt werden.

In einer bevorzugten Ausgestaltung der Anordnung weist das Sicherungsmodul mindestens eine elektronische Sicherung auf. Bevorzugt weist das Sicherungsmodul mindestens eine zweipolig trennende Sicherung auf. Durch die weiteren Querverbinder, die den Verdrahtungsaufwand reduzieren, kann auch ein System mit zweipoliger Absicherung ohne übermäßigen Verdrahtungsaufwand aufgebaut werden. Zudem stehen durch die Verteilung des positiven und des negativen Einspeisepotentials bereits an jedem Sicherungsmodul beide für die zweipolige Trennung benötigten Potentiale zur Verfügung.

In einer weiteren bevorzugten Ausgestaltung der Anordnung weist das Verteilermodul ein Trennelement auf, über das Anschlussklemmen trennbar mit den Anschlüssen für die Querverbinder verbunden sind. Das Trennelement kann beispielsweise als eine abziehbare Brücke ausgestaltet sein. Die Trennung kann dabei ein- oder allpolig vorgenommen werden. Das Trennelement ermöglicht auf einfache Weise, einen einzelnen zu versorgende Komponenten oder eine Gruppe von Komponenten zu beispielsweise Servicezwecken stromlos zu schalten.

In einer weiteren bevorzugten Ausgestaltung der Anordnung weist das Einspeisemodul einen Erdungsanschluss und ein Trennelement auf, wobei der Erdungsanschluss über das Trennelement trennbar mit einem der Anschlüsse für die Querverbinder verbunden ist. In vielen Niederspannungssystemen wird das negative Potential (Minuspol) auf ein Erdpotential gelegt, was über den Erdanschluss des Einspeisemoduls so auf einfache Weise möglich ist. Das Trennelement ermöglicht dabei ein Auftrennen dieser Erdverbindung, beispielsweise zu Wartungszwecken oder zur Durchführung von Isolationsmessungen. Alternativ kann das Trennelement auch durch eine feste, nicht trennbare elektrische Verbindung, ersetzt sein.

In einer weiteren bevorzugten Ausgestaltung der Anordnung weist das Sicherungsmodul mindestens einen Anschluss für einen zusätzlichen Querverbinder zur Übertragung eines Alarm- und/oder Steuersignals auf. Der zusätzliche Querverbinder ist bevorzugt als ein Datenbus, besonders bevorzugt als ein Eindraht-Datenbus ausgebildet, um die Alarm- und/oder Steuersignale in kodierter Form zu übertragen. Auf diese Weise können Steuer- und Alarmsignale eines oder auch mehrerer Sicherungsmodule gesammelt über den Datenbus übertragen werden. Anstelle von einer Mehrzahl von einzelnen Steueranschlüssen und/oder Alarmanschlüssen, die an jedem Sicherungsmodul vorgesehen und beschaltet werden müssen, kann so auch im Hinblick auf Steuer- und/oder Alarmsignale eine einfache Verschaltung über Querverbinder erfolgen.

Zu Auswertung der Steuer- und/oder Alarmsignale kann die Anordnung ein Signalverarbeitungsmodul mit mindestens einem Anschluss für den zusätzlichen Querverbinder aufweisen, das darüber hinaus Alarm- und/oder Steuersignalanschlüsse aufweist, an denen die über den Datenbus ausgetauschten Alarm- und/oder Steuersignale in dekodierter Form bereitstellt werden. Alternativ kann auch ein Einspeisemodul mit mindestens einem Anschluss für den zusätzlichen Querverbinder ausgestattet sein und Alarm- und/oder Steuersignalanschlüsse aufweisen. Das Einspeisemodul umfasst weiterhin einen Busdekodierer, der an den Alarm- und/oder Steuersignalanschlüssen die über den Datenbus ausgetauschten Alarm- und/oder Steuersignale in dekodierter Form bereitstellt. So kann eine Steuer- und/oder Alarmsignalbeschaltung für mehrere Sicherungsmodule zusammengefasst an dem Signalverarbeitungsmodul oder dem mit Busdekodierer versehenen Einspeisemodul erfolgen.

Die erfindungsgemäße Anordnung wird nachfolgend anhand von Ausführungsbeispielen mithilfe von Figuren näher erläutert.

Die Figuren zeigen:
- Fig. 1: eine schematische Darstellung einer Anordnung mehrerer Module zur Stromverteilung in einem Niederspannungssystem in einem ersten Ausführungsbeispiel;
- Fig. 2: eine schematische Darstellung eines Sicherungsmoduls einer Anordnung zur Stromverteilung;
- Fig. 3 bis 5: jeweils ein weiteres Ausführungsbeispiel einer Anordnung zur Stromverteilung in einem Niederspannungssystem.

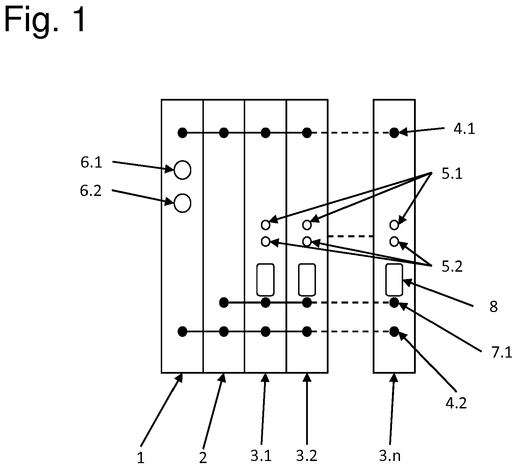

Fig. 1 zeigt in einer schematischen Blockdarstellung eine Anordnung mehrerer auf eine hier nicht gezeigte Tragschiene aufsetzbarer Module zur Stromverteilung in einem Niederspannungssystem.

Bei dieser Anordnung ist ein Einspeisemodul 1 vorgesehen, das Anschlussklemmen 6.1 und 6.2 aufweist, über die jeweils ein einpoliges Anschlusskabel mit großem Leiterquerschnitt von einer Stromversorgungseinheit zugeführt werden kann. Die hier nicht dargestellte Stromversorgungseinheit kann bevorzugt ebenfalls auf eine Tragschiene aufgesetzt werden und stellt an ihrem Ausgang eine Niederspannung, beispielsweise eine Spannung von 24 Volt (V), mit einer Strombelastbarkeit von einigen Ampere (A) bis etwa 100 A bereit.

Der an den Anschlussklemmen 6.1 (positives Potential; Pluspol) und 6.2 (negatives Potential; Minuspol) zugeführte Strom wird von der hier gezeigten Anordnung auf eine Mehrzahl von stromverbrauchenden Komponenten (Verbrauchern) verteilt.

Zu diesem Zweck sind an der Einspeiseklemme 1 Querverbinder-Kontakte ausgebildet, in die jeweils ein quer zum Modul, d.h. in Richtung der Tragschiene verlaufender Querverbinder 4.1 bzw. 4.2 eingesetzt werden kann. Die Querverbinder 4.1 bzw. 4.2 sind in diesem Sinne jeweils beispielsweise einpolige stangenförmige Leiter, die auch als "bus bar" bezeichnet werden. Alternativ können auch sogenannte Kammschienen als Querverbinder 4.1 und 4.2 verwendet werden.

Über die Querverbinder 4.1 und 4.2 wird das an den Anschlussklemmen 6.1 und 6.2 zugeführte Potential auf einfache Weise an aneinandergereihte weitere Module verteilt. Im dargestellten Beispiel schließt sich als weiteres Modul ein Sicherungsmodul 2 an, das mindestens eines der beiden über die Querverbinder 4.1 und 4.2 zugeführten Potentiale absichert. Das Sicherungsmodul 2 kann eine elektronische oder auch eine elektromechanische oder eine Schmelzsicherung sein. Das abgesicherte Potential wird an einem weiteren Querverbinder-Anschluss bereitgestellt, von dem aus es über einen weiteren Querverbinder 7.1 an weitere Module verteilt wird. Es wird davon ausgegangen, dass in dem dargestellten Beispiel der Querverbinder 7.1 im Sicherungsmodul 2 über die Sicherung mit dem Querverbinder 4.1 für das positive Potential verbunden ist. Über den Querverbinder 7.1 wird also das positive Potential (Pluspol) abgesichert weitergeleitet. Der weitere Querverbinder 7.1 kann ebenso wie die Querverbinder 4.1 und 4.2 als "bus bar" oder als Kammschiene ausgebildet sein.

An das Sicherungsmodul 2 schließt sich ein Verteilermodul 3 oder eine Mehrzahl von Verteilermodulen 3 an, hier beispielhaft die Verteilermodule 3.1, 3.2 bis 3.n. Über die Querverbinder 4.1, 4.2 und 7.1 kann das ungesicherte ebenso wie das abgesicherte Potential leicht von dem Einspeisemodul 1 bzw. dem Sicherungsmodul 2 an die Verteilermodule 3 weitergegeben werden.

Die Verteilermodule 3 weisen jeweils paarweise Leiteranschlüsse 5.1 und 5.2 auf, an denen das negative Potential direkt (vom Anschluss des Querverteilers 4.2) und das positive Potential abgesichert (vom Anschluss des Querverteilers 7.1) für die zu versorgenden Komponenten bereitgestellt wird. Bei dem dargestellten Ausführungsbeispiel ist jeweils nur ein Leiteranschlusspaar mit Leiteranschlüssen 5.1 und 5.2 pro Verteilermodul 3 gezeigt. Jedes Verteilermodul kann jedoch eine Mehrzahl derartiger Leiteranschlusspaare 5.1 und 5.2 aufweisen, die zueinander parallel geschaltet sind. Die Leiteranschlüsse 5.1 und 5.2 sind beispielsweise als Anschlussklemmen, z.B. Schraubklemmen oder schraubenlose Einsteckklemmen ausgebildet.

Zusätzlich kann bei jedem Verteilermodul 3 optional ein Trennelement 8 vorgesehen sein, über das die Leiteranschlüsse 5.1 und 5.2 von den Querverbindern 4.2 bzw. 7.1 getrennt werden können. Das Trennelement 8 kann beispielsweise als eine abziehbare Brücke ausgestaltet sein. Die Trennung kann dabei ein- oder allpolig vorgenommen werden. Das Trennelement 8 ermöglicht auf einfache Weise, eine einzelne zu versorgende Komponente oder eine Gruppe von Komponenten zu beispielsweise Servicezwecken stromlos zu schalten.

Bei der anmeldungsgemäßen Anordnung sind alle Querverbinder 4.1, 4.2 und 7.1 mit einer vorgegebenen und für alle Querverbinder gleich hohen maximalen Strombelastbarkeit ausgebildet. Dieses gilt insbesondere auch für den Querverbinder 4.2, der das negative Potential der Stromversorgungseinheit verteilt. Auf diese Weise kann ausgehend von den Leiteranschlüssen 5.1 und 5.2 sämtlicher von der Stromversorgungseinheit bereitgestellter Strom ohne eine zusätzliche Hilfsverdrahtung verteilt werden.

Die in Fig. 1 dargestellte Anordnung kann auf einfache Weise beispielsweise an ihrer rechten Seite um ein weiteres Sicherungsmodul 2 ergänzt werden, das wiederum an die Querverbinder 4.1 und 4.2 angeschlossen ist und einen weiteren Querverbinder 7.1 bereitstellt, an den weitere Verteilermodule 3 angeschlossen werden können.

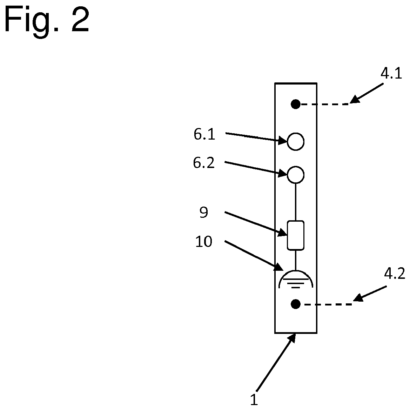

Fig. 2 zeigt eine besondere Ausgestaltung eines Einspeisemoduls 1, das beispielsweise in der Anordnung gemäß Fig. 1 Verwendung finden kann. Das in Fig. 2 dargestellte Einspeisemodul 1 weist einen Erdanschluss 10 auf, über den ein Erdpotential an das Einspeisemodul 1 angelegt werden kann. Über ein Trennelement 9 ist die Anschlussklemme 6.2 zur Einspeisung des negativen Potentials der Stromversorgungseinheit mit dem Erdanschluss verbunden. In vielen Niederspannungssystemen wird das negative Potential (Minuspol) auf ein Erdpotential gelegt, was über den Erdanschluss 10 des Einspeisemoduls 1 hier auf einfache Weise möglich ist. Das Trennelement 9 ermöglicht dabei ein Auftrennen dieser Erdverbindung, beispielsweise zu Wartungszwecken oder zur Durchführung von Isolationsmessungen. Alternativ kann das Trennelement auch durch eine feste, nicht trennbare elektrische Verbindung, ersetzt sein.

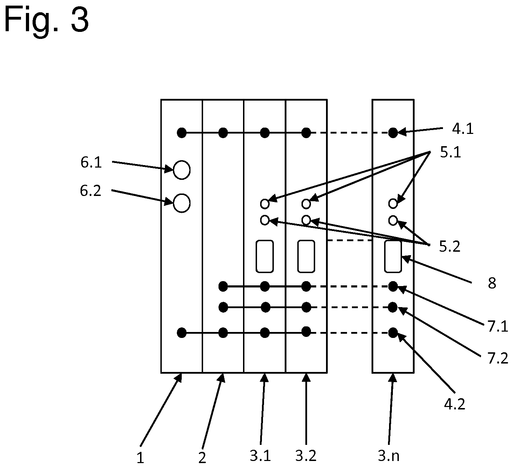

Fig. 3 zeigt eine mit Fig. 1 vergleichbare Anordnung zur Stromverteilung in einem Niederspannungssystem. Bezüglich des grundsätzlichen Aufbaus wird auf die Ausführungen zu Fig. 1 verwiesen. Im Unterschied zum Ausführungsbeispiel der Fig. 1 ist bei der in Fig. 3 dargestellten Anordnung das Sicherungsmodul 2 als eine allpolige Sicherung ausgebildet, bei der eine Trennung bei positiven als auch bei dem negativen Potential vorgenommen wird. Entsprechend wird nicht nur der abgesicherte Pluspol der Stromversorgung über den Querverbinder 7.1 weitergeleitet, sondern auch ein abgesicherter Minuspol der Stromversorgung über einen zweiten weiteren Querverbinder 7.2. Es versteht sich, dass die Anordnung der weiteren Querverbinder 7.1 und 7.2, die im dargestellten Beispiel beide in dem in der Figur unteren Bereich der Module positioniert sind, rein beispielhaft ist. Es wäre genauso möglich, den weiteren Querverbinder 7.1 benachbart zum Querverbinder 4.1 und dem weiteren Querverbinder 7.2 benachbart zum Querverbinder 4.2 anzuordnen. Die dargestellten Trennelemente 8 können wie bei Fig. 1 beschrieben zur Trennung eines oder auch beider Potentiale an den Leiteranschlüssen 5.1 und 5.2 ausgebildet sein.

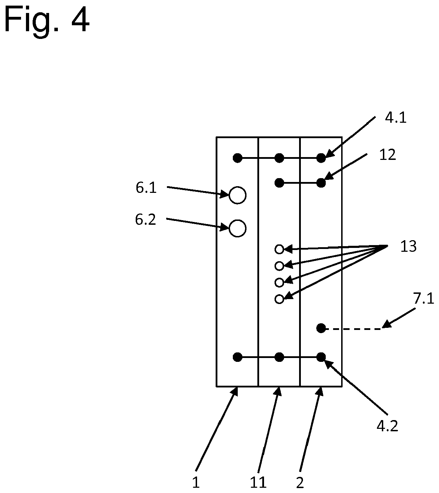

Fig. 4 zeigt eine weitere Anordnung zur Stromverteilung in einem Niederspannungssystem. Bei diesem Beispiel ist wiederum ein Einspeisemodul 1 vorgesehen, das mit einem Sicherungsmodul 2 verbunden ist. Sich an das Sicherungsmodul 2 anschließende Verteilermodule 3 (vgl. Fig. 1, 3) sind bei diesem Ausführungsbeispiel aus Gründen der Übersichtlichkeit nicht dargestellt. Bei diesem Ausführungsbeispiel ist das Sicherungsmodul 2 mit einer Steuer- und/oder Alarmfunktionalität ausgestattet. Aus dem Stand der Technik bekannte Sicherungsmodule weisen zu diesem Zweck separate Anschlusskontakte auf, über die ein Steuersignal zugeführt oder ein Alarmsignal abgegeben werden kann. Bei dem anmeldungsgemäßen System ist eine Busleitung in Art eines zusätzlichen Querverbinders 12 vorgesehen, über die sowohl Steuer-, als auch Alarmsignale vom Sicherungsmodul 2 abgegeben bzw. empfangen werden können. Besonders bevorzugt ist die Busleitung als ein Eindrahtbus ausgebildet, so dass nur der eine dargestellte zusätzliche Querverbinder 12 benötigt wird. Zur Dekodierung der Bussignale ist ein Signalverarbeitungsmodul 11 vorgesehen, das über den zusätzlichen Querverbinder 12 mit dem Sicherungsmodul 2 verbunden ist und das an Alarm- und/oder Steuersignalanschlüssen 13 die Alarm- und/oder Steuersignale in dekodierter Form bereitstellt.

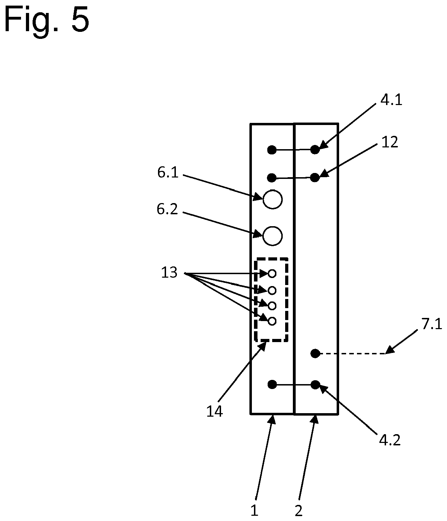

Fig. 5 zeigt eine zu Fig. 4 alternative Anordnung zur Stromverteilung in einem Niederspannungssystem. Bei diesem Ausführungsbeispiel erfolgt eine Dekodierung der Bussignale nicht in einem separaten Signalverarbeitungsmodul (11, vgl. Fig. 4), sondern in einem Einspeisemodul 1, das einen integrierten Busdekodierer 14 aufweist. Ein solches Einspeisemodul 1 verfügt dann zusätzlich über einen Anschluss für den Querverbinder 12 sowie über Alarm- und/oder Steuersignalanschlüsse 13.

Besonders vorteilhaft ist es, wenn das in Fig. 4 dargestellte Signalverarbeitungsmodul 11 oder das in Fig. 5 dargestellte Einspeisemodul 1 mit integriertem Busdekodierer 14 dazu eingerichtet sind, Alarm- und/oder Steuersignale mehrerer Sicherungsmodule 2 zu verarbeiten, die alle miteinander und mit dem Signalverarbeitungsmodul 11 bzw. dem Einspeisemodul 1 mit integriertem Busdekodierer 14 über den zusätzlichen Querverbinder 12 gekoppelt sind. Als Bussystem kann beispielsweise ein Eindraht- (1-wire) CAN (controller area network)-Bus verwendet werden.

### Bezugszeichenliste

- 1: Einspeisemodul
- 2: Sicherungsmodul
- 3.1 bis 3.n: Verteilermodul
- 4.1: Querverbinder (positives Versorgungspotential)
- 4.2: Querverbinder (negatives Versorgungspotential)
- 5.1: Leiteranschluss
- 5.2: Leiteranschluss
- 6.1: Anschlussklemme Einspeisung (positives Potential)
- 6.2: Anschlussklemme Einspeisung (negatives Potential)
- 7.1: weiterer Querverbinder (abgesichertes positives Potential)
- 7.2: weiterer Querverbinder (abgesichertes negatives Potential)
- 8: Trennelement
- 9: Trennelement
- 10: Erdanschluss
- 11: Signalisierungsmodul
- 12: zusätzlicher Querverbinder für Signale
- 13: Alarm- und/oder Steuersignalanschluss
- 14: integrierter Busdekodierer

## Patentansprüche

1. Anordnung zur Stromverteilung in einem Niederspannungssystem, aufweisend mehrere scheibenförmige, aneinanderreihbare und auf eine Tragschiene aufsetzbare, bevorzugt aufrastbaren Module, wobei mindestens ein Einspeisemodul (1), mindestens ein Sicherungsmodul (2) und mindestens ein Verteilermodul (3.1 bis 3.n) vorgesehen ist, wobei die Module mindestens
- einen Anschluss für einen ersten Querverbinder (4.1) für ein positives Potential und
- einen Anschluss für einen zweiten Querverbinder (4.2) für ein negatives Potential,
aufweisen und wobei
- das Sicherungsmodul (1) und das Verteilermodul (3) jeweils einen weiteren Anschluss für einen weiteren Querverbinder (7.1, 7.2) für ein durch das Sicherungsmodul (2) abgesichertes Potential aufweisen, um mindestens eines der beiden über den ersten oder zweiten Querverbinder (4.1, 4.2) zugeführten Potentiale über den mindestens einen weiteren Querverbinder (7.1, 7.2) abgesichert weiterzuleiten, wobei die Anschlüsse für den jeweiligen Querverbinder (4.1, 4.2, 7.1, 7.2) an den Gehäusen der einzelnen Modulen so in einer Flucht liegen, dass sie durch einen durchgehenden, geraden Querverbinder miteinander verbunden werden können.

2. Anordnung nach Anspruch 1, bei der das Sicherungsmodul (2) mindestens eine elektronische Sicherung aufweist.

3. Anordnung nach Anspruch 1 oder 2, bei der das Sicherungsmodul (2) mindestens eine zweipolig trennende Sicherung aufweist.

4. Anordnung nach einem der Ansprüche 1 bis 3, bei der das Verteilermodul (3) ein Trennelement (8) aufweist, über das Anschlussklemmen (5.1, 5.2) trennbar mit den Anschlüssen für die Querverbinder (4.1, 4.2, 7.1, 7.2) verbunden sind.

5. Anordnung nach einem der Ansprüche 1 bis 4, bei der das Einspeisemodul (1) einen Erdungsanschluss (10) und ein Trennelement (9) aufweist, wobei der Erdungsanschluss (10) über das Trennelement (9) trennbar mit einem der Anschlüsse für die Querverbinder (4.1, 4.2) verbunden ist.

6. Anordnung nach einem der Ansprüche 1 bis 5, bei der das Sicherungsmodul (2) mindestens einen Anschluss für einen zusätzlichen Querverbinder (12) zur Übertragung eines Alarm- und/oder Steuersignals aufweist.

7. Anordnung nach Anspruch 6, wobei der zusätzliche Querverbinder (12) als ein Datenbus, bevorzugt als ein Eindraht-Datenbus, ausgebildet ist, um die Alarm- und/oder Steuersignale in kodierter Form zu übertragen.

8. Anordnung nach Anspruch 7, wobei ein Signalverarbeitungsmodul (11) mit mindestens einem Anschluss für den zusätzlichen Querverbinder (12) vorgesehen ist, das Alarm- und/oder Steuersignalanschlüsse (13) aufweist, an denen die über den Datenbus ausgetauschten Alarm- und/oder Steuersignale in dekodierter Form bereitstellt werden.

9. Anordnung nach Anspruch 7, wobei das Einspeisemodul (1) mindestens einen Anschluss für den zusätzlichen Querverbinder (12) und Alarm- und/oder Steuersignalanschlüsse (13) aufweist und einen Busdekodierer (14) umfasst, wobei an den Alarm- und/oder Steuersignalanschlüssen (13) die über den Datenbus ausgetauschten Alarm- und/oder Steuersignale in dekodierter Form bereitstellt werden.

## Claims

1. An assembly for distributing current in a low-voltage system, comprising several disk-shaped modules that can be arranged in series and set, preferably locked on a carrying rail wherein at least one supply module (1), at least one a fuse module (2) and at least one distributor module (3.1 to 3.n) are provided, wherein the modules comprise at least
- one connection for a first cross connector (4.1) for a positive potential and
- one connection for a second cross connector (4.2) for a negative potential and wherein
- the fuse module (1) and the distributor model (3) each comprise one other connection for another cross connector (7.1, 7.2) for a potential secured by the fuse module (2), in order to forward at least one of the two potentials supplied via the first or second cross connector (4.1, 4.2) via the at least one other cross connector (7.1, 7.2) in a protected manner, wherein the connections for the particular cross connector (4.1, 4.2, 7.1, 7.2) rest on the housings of the individual modules in such an alignment, that they can be connected to each other by a continuous, straight cross connector.

2. The assembly according to Claim 1, in which the fuse module (2) comprises at least one electronic fuse.

3. The assembly according to Claim 1 or 2, in which the fuse module (2) comprises at least one fuse separating in a two-pole manner.

4. The assembly according to one of Claims 1 to 3, in which the distributor module (3) comprises a separating element (8) by which the connection clamps (5.1, 5.2) are separably connected to the connections for the cross connectors (4.1, 4.2, 7.1, 7.2).

5. The assembly according to one of Claims 1 to 4, in which the supply module (1) comprises a ground connection (10) and a separating element (9), wherein the ground connection (10) is separably connected via the separating element (9) to one of the connections for the cross connectors (4.1, 4.2).

6. The assembly according to one of Claims 1 to 5, in which the fuse module (2) comprises at least one connection for an additional cross connector (12) for transmitting an alarm- and/or control signal.

7. The assembly according to Claim 6, wherein the additional cross connector (12) is constructed as a data bus, preferably as a one-wire data bus in order to transmit the alarm-and/or control signals in encoded form.

8. The assembly according to Claim 7, wherein a signal processing module (11) is provided with at least one connection for the additional cross connector (12) which comprises alarm-and/or control signal connections (13) on which the alarm-and/or control signals exchanged via the data bus are made available in decoded form.

9. The assembly according to Claim 7, wherein the supply module (1) comprises at least one connection for the additional cross connector (12) and alarm-and/or control signal connections (13) and comprises a bus decoder (14), wherein the alarm-and/or control signals exchanged via the data bus are made available in decoded form on the alarm-and/or control signal connections (13).

## Revendications

1. Agencement pour la distribution de courant dans un système basse tension, présentant plusieurs modules en forme de disque juxtaposables, pouvant être montés sur un rail porteur et de préférence encliquetables, au moins un module d'alimentation (1), au moins un module à fusibles (2) et au moins un module de distribution (3.1 à 3.n) étant prévus, lesquels modules présentent au moins
- une connexion pour un premier connecteur transversal (4.1) pour un potentiel positif et
- une connexion pour un deuxième connecteur transversal (4.2) pour un potentiel négatif et
- le module à fusibles (1) et le module de distribution (3) présentant chacun une autre connexion pour un autre connecteur transversal (7.1, 7.2) pour un potentiel protégé par le module à fusibles (2) afin de transmettre au moins l'un des deux potentiels amenés par le premier ou le deuxième connecteur transversal (4.1, 4.2) par l'intermédiaire dudit au moins un autre connecteur transversal (7.1, 7.2), les connexions pour le connecteur transversal respectif (4.1, 4.2, 7.1, 7.2) étant alignées sur les boîtiers des modules individuels de manière à pouvoir être reliées entre elles par un connecteur transversal droit continu.

2. Agencement selon la revendication 1, dans lequel le module à fusibles (2) présente au moins un fusible électronique.

3. Agencement selon la revendication 1 ou 2, dans lequel le module à fusibles (2) présente au moins un fusible à séparation bipolaire.

4. Agencement selon l'une des revendications 1 à 3, dans lequel le module de distribution (3) présente un élément de séparation (8) par lequel les bornes de connexion (5.1, 5.2) sont reliées de manière séparable aux connexions pour les connecteurs transversaux (4.1, 4.2, 7.1, 7.2).

5. Agencement selon l'une des revendications 1 à 4, dans lequel le module d'alimentation (1) présente une connexion de mise à la terre (10) et un élément de séparation (9), la connexion de mise à la terre (10) étant reliée de manière séparable à l'une des connexions pour les connecteurs transversaux (4.1, 4.2) par l'élément de séparation (9).

6. Agencement selon l'une des revendications 1 à 5, dans lequel le module à fusibles (2) présente au moins une connexion pour un connecteur transversal supplémentaire (12) pour la transmission d'un signal d'alarme et/ou de commande.

7. Agencement selon la revendication 6, dans lequel le connecteur transversal supplémentaire (12) est réalisé sous la forme d'un bus de données, de préférence sous la forme d'un bus de données unifilaire, afin de transmettre les signaux d'alarme et/ou de commande sous forme codée.

8. Agencement selon la revendication 7, dans lequel il est prévu un module de traitement de signaux (11) avec au moins une connexion pour le connecteur transversal supplémentaire (12), qui présente des connexions de signaux d'alarme et/ou de commande (13) auxquelles les signaux d'alarme et/ou de commande échangés via le bus de données sont fournis sous forme décodée.

9. Agencement selon la revendication 7, dans lequel le module d'alimentation (1) présente au moins une connexion pour le connecteur transversal supplémentaire (12) et des connexions de signaux d'alarme et/ou de commande (13) et comprend un décodeur de bus (14), les signaux d'alarme et/ou de commande échangés via le bus de données étant fournis sous forme décodée aux connexions de signaux d'alarme et/ou de commande (13).
